Europäisches Patentamt

European Patent Office

Office européen des brevets

(19)

(11) Publication number: **0 311 331**
**A2**

## (12) EUROPEAN PATENT APPLICATION

(21) Application number: 88309174.6

(22) Date of filing: 03.10.88

(51) Int. Cl.⁴: **H01L 39/24 , H01L 39/14**

(30) Priority: 07.10.87 GB 8723516

(43) Date of publication of application:
12.04.89 Bulletin 89/15

(84) Designated Contracting States:
**BE DE FR IT NL**

(71) Applicant: **UNITED KINGDOM ATOMIC ENERGY AUTHORITY**
**11 Charles II Street**
**London SW1Y 4QP(GB)**

(72) Inventor: **Rutt, Harvey Nicholas**
**22 Galleyfield**
**Abingdon Oxon OX14 3RT(GB)**

(74) Representative: **Wood, Paul Austin et al**
**Patents Branch United Kingdom Atomic Energy Authority 11 Charles II Street London SW1Y 4QP(GB)**

(54) Superconducting ceramic circuit elements.

(57) A method of manufacturing an electrical circuit element from high temperature superconducting ceramic materials as hereinbefore defined, comprising the operation of scanning over regions of the surface of a body of superconducting ceramic material a beam of radiation having an energy density sufficient to raise the temperature of irradiated regions of the body of superconducting material to a level sufficient to destroy the superconducting properties of the ceramic material so as to provide regions of the body of ceramic material which no longer are superconducting interspersed with regions which still are superconducting so as to form the said electrical circuit element.

EP 0 311 331 A2

## Superconducting ceramic circuit elements

The present invention relates to the processing of high temperature superconducting ceramic materials to provide electrical circuit elements.

For the purpose of this specification high temperature superconducting ceramic materials are defined as ceramic materials which show superconducting properties at temperatures above that of liquid helium (4.0° K).

The recently discovered high temperature superconducting materials such as $YBa_2Cu_3O_9-\delta$ or $TmBa_2Cu_3O_9-\delta$ are brittle ceramics. As such their fabrication into useful electrical circuit elements produces difficulties because they cannot be drawn or rolled into wires, although wire-like forms have been produced by the reduction in size of tubes of malleable metal filled with powdered superconducting ceramic material.

It is known that superconducting ceramic materials lose their superconducting properties if they are rapidly quenched from a high temperature or are heated in an oxygen deficient atmosphere.

According to the present invention there is provided a method of manufacturing an electrical circuit element from high temperature superconducting ceramic materials as hereinbefore defined, comprising the operation of scanning over regions of the surface of a body of superconducting ceramic material a beam of radiation having an energy density sufficient to raise the temperature of irradiated regions of the body of superconducting material to a level above that required permanently to destroy the superconducting properties of the ceramic material so as to provide regions of the body of ceramic material which no longer are superconducting interspersed with regions which still are superconducting so as to form the said electrical circuit element.

The transition from a superconducting to a permanent non-superconducting state can be facilitated rapid cooling of the scanned regions of the body of ceramic material, carrying out the operation in an oxygen-deficient atmosphere or vacuum, or by a combination of the two effects.

The beam of radiation may be provided by a laser, the beam diameter, power density and scanning speed being chosen according to the particular superconducitng ceramic material, thickness and desired non-superconducting line width.

The invention will now be described, by way of example, with reference to the accompanying drawings in which:

Figure 1 illustrates diagramatically a method of producing a helical superconducting structure suitable for use as a solenoid,

Figure 2 illustrates the formation of a form of coil suitable for use as a field coil in an electric motor, and

Figure 3 shows a longitudinal section of a cylindrical superconducting ceramic body suitable for use in the embodiments of Figures 1 and 2.

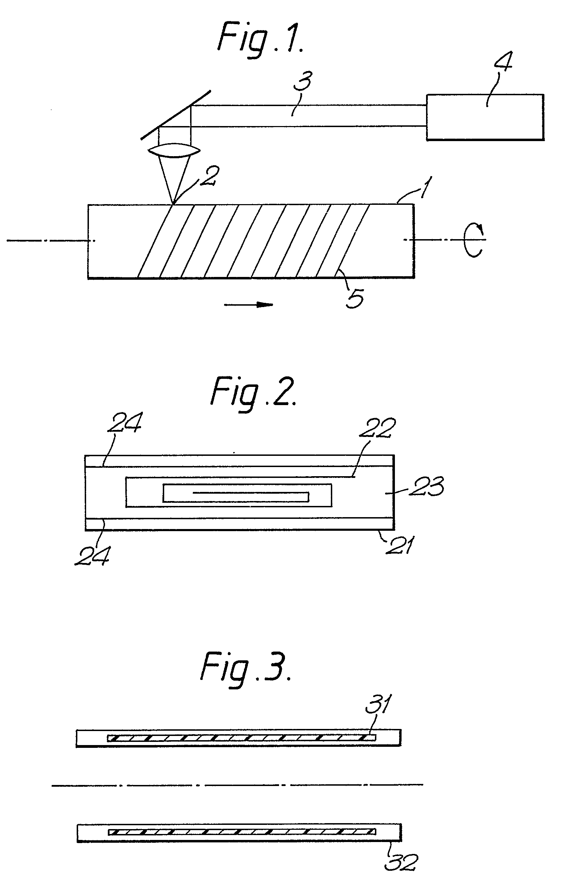

Referring now to Figure 1, a cylindrical body 1 of a high temperature superconducting ceramic material such as $YBa_2Cu_3O_9-\delta$ or $TmBa_2Cu_3O_9-\delta$ is rotated and translated by a mechanism, which is not illustrated, under the focus 2 of a beam 3 of radiation from a $CO_2$ or Nd:YAg laser 4. As a result the focussed laser beam 3 traces out a helical path 5 on the cylinder 1 of superconducting ceramic material. The energy density, focal spot size and tracking speed are chosen to be such the the temperature of the superconducting ceramic material of the cylinder 1 along the helical path 5 is raised to a value such that it ceases to be superconducting, thus leaving a helix of superconducting material. The transition from a superconducting to a non-superconducting state can be facilitated either by directing a jet of cooling inert gas at the surface of the cylinder 1 just behind the focal spot 2 of the laser beam 3, or by carrying out the process in a vacuum or an oxygen deficient atmosphere.

Figure 2 shows another cylinder 21 of superconducting ceramic material which has been moved in such a way that the non-superconducting path 5 forms a flat spiral 22 in a region 23 of the cylinder 21 which is isolated by two parallel non-superconducting lines 24. By repeating this configuration at regular intervals around the periphery of the cylinder 21, coils suitable for use as field coils in an electric motor can be made.

To be fully effective, the non-superconducting region, or regions, must fully penetrate the body of superconducting ceramic material. Hence the width of the processed line must be commensurate with the thickness of the superconducting ceramic body. It may be possible to reduce the line width by simultaneous processing from each side of the superconducting ceramic body as the penetration required effectively is halved.

For some purposes it may be necessary to use thin layers of superconducting ceramic material, and these may be too fragile on their own. This problem can be overcome by forming the layer of superconducting ceramic material upon a substrate of another non-superconducting ceramic material such as $LaBa_2Cu_3O_9-\delta$ or $(Y_xLa_{1-x})Ba_2Cu_3O_9-\delta$. Figure 3 shows such an arrangement in which a cylindrical 31 of nonsuperconducting ceramic material is buried within superconducting ceramic material 32. By this means, different superconducting and non-superconducting patterns can be written on each side of the central nonsuperconducting ceramic material.

In order to reduce the likelihood of cracking or other damage due to thermal shock it may be advantageous to pre-heat the superconducting body to a temperature somewhat below that at which the transition to a permanent nonsuperconducting state occurs (~500° C).

## Claims

1 A method of manufacturing an electrical circuit element from high temperature superconducting ceramic materials as hereinbefore defined, comprising the operation of scanning over regions (5, 7) of the surface of a body (1) of superconducting ceramic material a beam of radiation (2, 3) having an energy density sufficient to raise the temperature of irradiated regions (5) of the body of superconducting material (1) to a level above that required permanently to destroy the superconducting properties of the ceramic material so as to provide regions (5) of the body (1) of ceramic material which no longer are capable of being made superconducting interspersed with regions which still are capable of being made superconducting so as to form the said electrical circuit element.

2 A method according to claim 1 wherein there is included the operation of rapidly cooling the heated regions of the ceramic body (1).

3 A method according to claim 1 or claim 2 wherein the heating of the regions (5) of the body of ceramic material (1) is carried out under vacuum conditions.

4 A method according to claim 1 or claim 2 wherein the heating of the regions (5) of the body of ceramic material (1) is carried out in an oxygen depleted atmosphere.

# Fig.1.

# Fig.2.

# Fig.3.